# EUROPEAN PATENT SPECIFICATION

(11) **EP 0 606 758 B1**
(45) Date of publication and mention of the grant of the patent: **06.09.2000**
(21) Application number: 93310488.7
(22) Date of filing: 23.12.1993
(51) Int. Cl.: H01L 27/108, H01L 21/82

(54) **Method of producing an SOI transistor DRAM**
Verfahren zur Herstellung einer SOI-Transistor-DRAM
Procédé de fabrication d'un dispositif DRAM à transistor SOI

(30) Priority: 30.12.1992 KR 9226778
(43) Date of publication of application: 20.07.1994
(73) Proprietor: SAMSUNG ELECTRONICS CO., LTD., Suwon-city, Kyungki-do 441-373 (KR)
(72) Inventor: Park, Kyucharn, Songtan, Kyungki-do (KR); Lee, Yeseung, Seocho-ku, Seoul (KR); Ban, Cheonsu, Seoul (KR); Lee, Kyungwook, Kyungki-do (KR)
(74) Representative: Kensett, John Hinton

(56) References cited:
- EP-A- 0 356 218
- PATENT ABSTRACTS OF JAPAN vol. 16, no. 347 (E-1240)27 July 1992 & JP-A-04 107 858 (NEC CORP) 9 April 1992
- PATENT ABSTRACTS OF JAPAN vol. 16, no. 564 (E-1295)4 December 1992 & JP-A-04 216 667 (SONY CORP) 6 August 1992
- PATENT ABSTRACTS OF JAPAN vol. 13, no. 280 (E-779)(3628) 27 June 1989 & JP-A-01 067 956 (FUJITSU LTD) 14 March 1989
- PATENT ABSTRACTS OF JAPAN vol. 15, no. 448 (E-1133)14 November 1991 & JP-A-03 190 164 (MATSUSHITY ELECTRIC IND CO LTD) 20 August 1991
- PATENT ABSTRACTS OF JAPAN vol. 17, no. 199 (E-1352)19 April 1993 & JP-A-04 342 166 (MITSUBISHI ELECTRIC CORP) 27 November 1992
- PATENT ABSTRACTS OF JAPAN vol. 15, no. 417 (E-1125)23 October 1991 & JP-A-03 173 175 (HITACHI LTD) 23 October 1991

## Description

The present invention relates generally to a dynamic random access memory (DRAM) and a method for making a dynamic random access memory. More particularly, the present invention relates to a dynamic random access memory made by using a modified silicon-on-insulator (SOI) technology in which transistors are formed by silicon direct bonding (SDB) and chemical-mechanical polishing (CMP) after capacitors are formed by silicon direct bonding and the silicon-on-insulator technology. In addition, it also relates to a method for making a dynamic random access memory by which SOI devices are formed just on specific areas including cells so that the technique now applied to the bulk silicon is used for devices of peripheral circuits, with advantages of SOI direct wafer bonding.

Remarkable progress has been made in the manufacture of Dynamic Random Access Memories (DRAM) using high integration technology. As the size of semiconductor devices reduces, the problem of securing a high capacitance becomes an issue. For example, a change in main stream production from 1M bit DRAMs to 4M bit DRAMs has been achieved.

In such a DRAM with high integration, the predetermined capacitance of the cell storage capacitor must be kept constant, in spite of the decrease in the area of the cells. For example, each area of a cell and a capacitor in a 64M bit DRAM decreases to about 0.8 µm²/1.0 µm^{2.}

Where the areas of charge storage capacitors are also decreased and the capacitance becomes small, soft errors may occur on exposure to α-light, and the problem of reliability becomes an issue. Accordingly, the capacitance of cell storage capacitors must be kept constant, in spite of the decrease in the areas of the capacitors, in order to obtain improved integration of a semiconductor device.

In a recent DRAM whose cells are based on transistor-stacked capacitor combinations, one of a pair of electrodes of a storage capacitor is formed to have a three-dimensional structure. This makes the capacitance larger, by 30 to 40%, than that of a two-dimensional capacitor having the same size as the three-dimensional one. However, the capacitance increases without the increase of cell areas or storage area. Various three-dimensional structures or high dielectric constant have been studied. One method for obtaining a high capacitance in defined small areas of capacitors, such as the above three-dimensional DRAMs is described in "A 1.28µm Bit-Line Shielded Memory Cell Technology for 64 MB DRAMS" - 1990 symposium of VLSI TECHNOLOGY.

Active parasitic devices arise such as parasitic metal oxide semiconductor transistors or parasitic bipolar transistors in a PN junction-separation structure that appears in a complementary metal oxide semiconductor structure. In addition, problems can occur of deterioration of electric devices and soft error due to latch-up phenomenon. In order to prevent these problems and attain high density, silicon-on-insulator (SOI) techniques have been studied in which insulating layers are formed as sidewalls of an insulating substrate formed of a material such as Si02 and silicon single crystalline wells are formed in these insulating layers to form semiconductor devices in the above wells.

These techniques have advantages of perfect isolation of electrical elements, high speed performance, and being latch-up and soft error free. That is, a semiconductor device such as CMOS circuits can be made. Second, the width of insulating layers for isolation depends on just photo-etching, etc. Third, high integration based on the micro-miniaturization can be obtained as well as the application with three-dimensional devices.

According to the above techniques, a semiconductor device of SOI structure is formed by forming an amorphous or polysilicon layer on an amorphous insulating substrate such as SiO₂ and performing recrystallization on the polysilicon layer. Separation by implanted oxygen (SIMOX) processes and full isolation by porous oxidized silicon (FIPOS) processes are also known, as another approach.

When it comes to the problems of these SIMOX technologies, specially designed oxide ion implanting means are required for forming an insulating layer inside a substrate. The FIPOS processes need anodization just for these processes. Also, zone melting (ZMR) requires recrystallization.

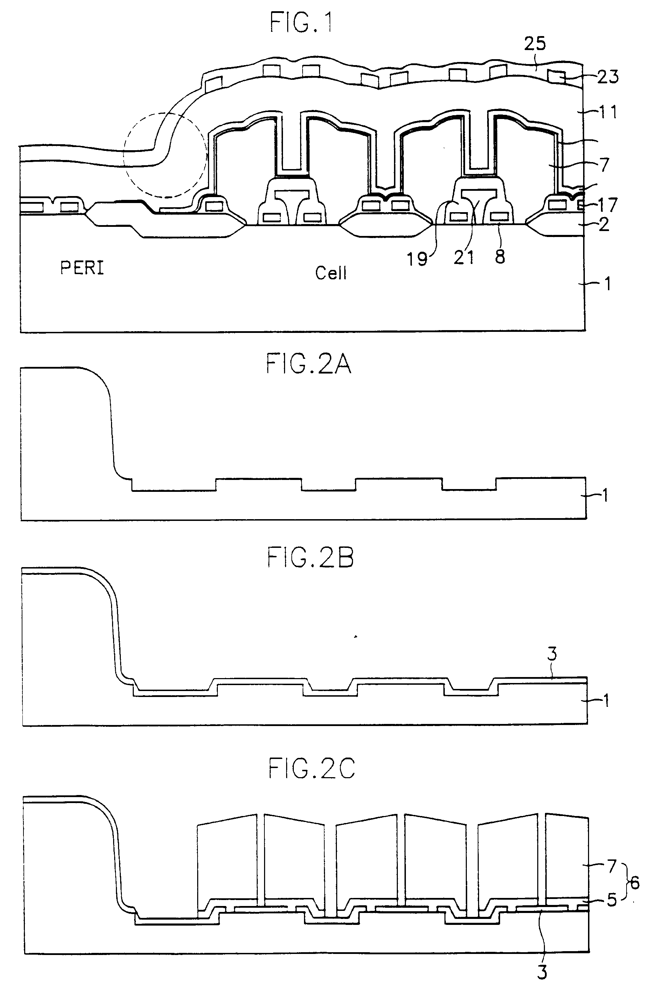

A method of forming a conventional DRAM is now described with reference to FIG. 1.

First, a field oxide layer 2 is formed by selective oxidation on a silicon substrate 1 and isolation of electrical elements is performed. Then, a gate oxide 8 is grown, and a gate electrode 17 is patterned to form a source/drain region. Inter layer insulation is carried out by an oxide layer 19 formed by chemical vapour deposition method, and a conductive layer 21 is deposited and patterned.

After a second interlayer insulation is carried out, a contact hole is opened so that a capacitor lower electrode 7 contacts the first silicon substrate, and the lower electrode 7 is patterned. A dielectric layer 10 and an upper electrode 9 are then formed.

Successively, after a third interlayer insulation is performed, a protective layer 25 is finally formed to complete the manufacture of the semiconductor memory cell.

As shown in the above process, in order to attain sufficient capacitance in the manufacture of the high integration DRAM more than the level of very large scale integrated circuits (VLSI), a stack type capacitor having a three-dimensionally enlarged area is applied.

As the integrity of the stack type capacitor is more than 64M, a storage node is formed in order to secure the capacitance of the cell capacitor. If the storage node is raised so that there is a large step difference between a cell part and a peripheral part, then contact or metallization is not easily performed.

In the formation of P-MOS transistors, there is a condition that thermal budget should be small in order to maintain transistor characteristics and isolation of electrical elements. It is hard to perform planarization by borophosphorsilicate glass (BPSG) flow due to this condition.

In line with the high integration of DRAMs, the degree of difficulty of forming patterns increases. This is not only because the size of patterns is small but because high overlay accuracy is necessary, and since there is a step-like difference as high as the height of the cell capacitor, it is difficult to secure an alignment margin.

If the planarity is increased so as to remove the step-like difference, the depth of contact for metallization is increased, too. Various problems may occur by step-coverage or etch damage.

Study has been made to attempt to solve the problems by forming a capacitor in advance by direct wafer bonding and silicon-on-insulator processes and then making transistors on the opposite silicon surface.

However, if a DRAM cell is made by this way, devices of peripheral circuits become SOI devices, and it is difficult to find a processing condition that meets both characteristics.

That is to say, n-type MOS and p-type MOS transistors having a width and a length different to each other should be made into SOI devices, and there is a difficulty forming active devices of different size on SOI.

JP 4216667 and JP 3190164 disclose semiconductor storage devices in which memory cells are formed by forming storage nodes.

An object of this invention is to provide a dynamic random access memory and a method for making the same, which is capable of preventing deterioration to characteristics of a transistor due to subsequent thermal treatment and problems of grounding plate, by forming the transistor after a cell area is deeply recessed on a semiconductor substrate having the cell area and a peripheral area, and a capacitor is formed.

A second object of this invention is to provide a method for making a dynamic random access memory using silicon-on-insulator so as to maintain the advantages of direct wafer bonding (DWB) and silicon-on-insulator (SOI) techniques and to apply the technique applied to the bulk silicon, directly to the devices of the peripheral circuit. This object can be achieved by forming just an access transistor in a cell area on a silicon-on-insulator of less than 100µm and forming devices other than the access transistor on a silicon-on-insulator of more than 1µm so as to display characteristics of devices formed on the bulk silicon.

According to the present invention in a first aspect there is provided a method for making a dynamic random access memory comprising the steps of: recessing a cell area of a lower surface of a silicon substrate by a first depth, wherein the substrate has the lower surface and an upper surface opposite the lower surface, and the lower surface is divided into the cell area where a memory device is formed and a peripheral area; forming a trench having a bottom area and a sidewall into the recessed cell area; forming a first insulating layer over the lower surface; forming a contact hole in the first insulating layer; depositing and patterning a first conductive layer to form a storage node in contact with the lower surface of the substrate through the contact hole; forming a dielectric layer on the storage node; forming a second conductive layer on the dielectric layer to form a plate node; planarizing the lower surface of the substrate; polishing the upper surface to expose the first insulating layer filled in the trench such that a portion of the upper surface opposite the cell area has a thin silicon on insulator layer surrounded by the trench and a portion of the upper surface opposite the peripheral area has a thick silicon on insulator layer; and forming a switching element on the upper surface of the thin silicon on insulator layer and the thick silicon on insulator layer.

The above and further objects, features and advantages of the present invention will become more apparent from the following detailed description of embodiments taken in conjunction with the accompanying drawings.
FIG. 1 is a sectional view of a conventional dynamic random access memory (DRAM);
FIGS. 2A to 2G depict the steps in the manufacture of a DRAM by silicon-on-insulator processes in accordance with a first preferred embodiment of this invention;
FIGS. 3A to 3I depict the steps in the manufacture of a DRAM by silicon-on-insulator processes in accordance with a second preferred embodiment of this invention;
FIG. 4 depicts a joining machine that is used at the time of manufacturing the DRAM in accordance with the second preferred embodiment of this invention.

A detailed description of the present invention will now be made referring to the accompanying drawings.

A first preferred embodiment of making a dynamic random access memory (DRAM) by silicon-on-insulator (SOI) techniques is described as follows.

FIGS. 2A to 2G depict the steps in the manufacture of a DRAM by silicon-on-insulator processes in accordance with a first preferred embodiment of this invention.

The method of manufacturing a dynamic random access memory (DRAM) includes the steps of dividing a cell part and a peripheral part on a first single crystalline silicon substrate 1 and recessing deeply just the cell part where a memory device is formed; forming a first insulating layer 3 by isolation to separate an active region and a passive region; forming and patterning first conductive polysilicon layers 5, 7 on the insulating layer 3 through a contact to which the active region and capacitor are connected to form a storage node 6; forming and patterning a capacitor dielectric layer and a polysilicon layer on the storage node 6 to form a plate node 9; forming and thermally treating a second insulating layer 11 on the plate node 9 to be planarized; forming another polysilicon layer 13 to a predetermined thickness on the planarized second insulating layer 11; polishing the polysilicon layer chemically and mechanically, using the second insulating layer as an etchstopper and bonding a handling wafer 15 on the polished first substrate; thinning a backside part of the first substrate 1 by a chemical-mechanical polishing method to expose an active silicon layer 1'; and after making a gate electrode 17 on the active silicon layer 1' and a predetermined device, applying a third insulating layer 19 and forming a bit line 21.

To explain the above processes in detail, the cell part where a memory device is deeply recessed after the cell part and the peripheral part are divided on the single-crystalline silicon substrate 1, as shown in FIG. 2A.

The cell part is recessed more than the height of the capacitor. After just the part that will be isolated in the recessed cell part is etched to a thickness of more than 500 angstroms by shallow trench technique, an oxide layer is formed for damage cure, and a high temperature oxide (HTO) and a borophosphorsilicate glass (BPSG) are united with each other to form an insulating layer 3 to a thickness in which can be isolated.

A first conductive layer of polysilicon is formed on the insulating layer 3 so thickly that sufficient capacitance can be obtained through the contact to which the active region and capacitor are connected. After patterning the first conductive layer, the storage node 6 is formed. The first conductive layer is deposited by a differential doped polysilicon deposition that forms a doped polysilicon layer 7 thickly, after an undoped polysilicon layer 5 is thinly formed. When a junction of the source region is formed by a successive thermal treatment after the capacitor processes, the above way prevents the junction from being formed too deeply. The first conductive layer is patterned to form the storage node 6.

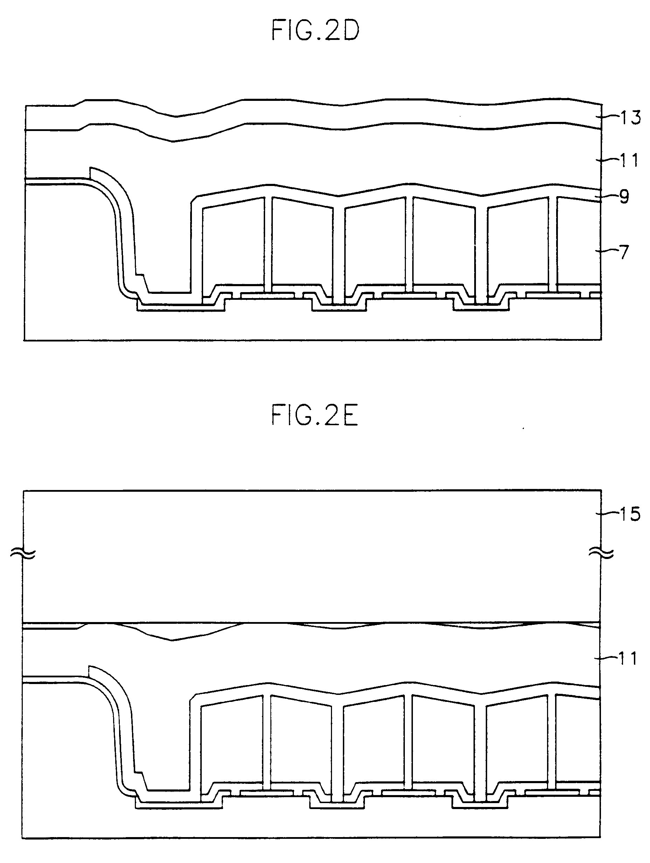

Dielectric layers of the capacitor are formed by various high dielectric materials such as oxide film/nitride film/oxide film that does not appear on the pattern where the storage node 6 is formed as shown in FIG. 2D. The second conductive layer, polysilicon is formed and patterned to form a plate node 9 thereby completing the capacitor processes.

After the insulating layer to which HTO and BPSG are united is thickly formed and planarized by thermal treatment, the polysilicon layer 13 is formed to a predetermined thickness.

As shown in FIG. 2E, the polysilicon layer 13 is planarized by CMP method in which the insulating layer 11 serves as an etch stopper, and a glass side of the handling wafer 15 is bonded on the planarized polysilicon layer. The bonding method is similar to a conventional way, i.e. the bonding is performed by thermal treatment.

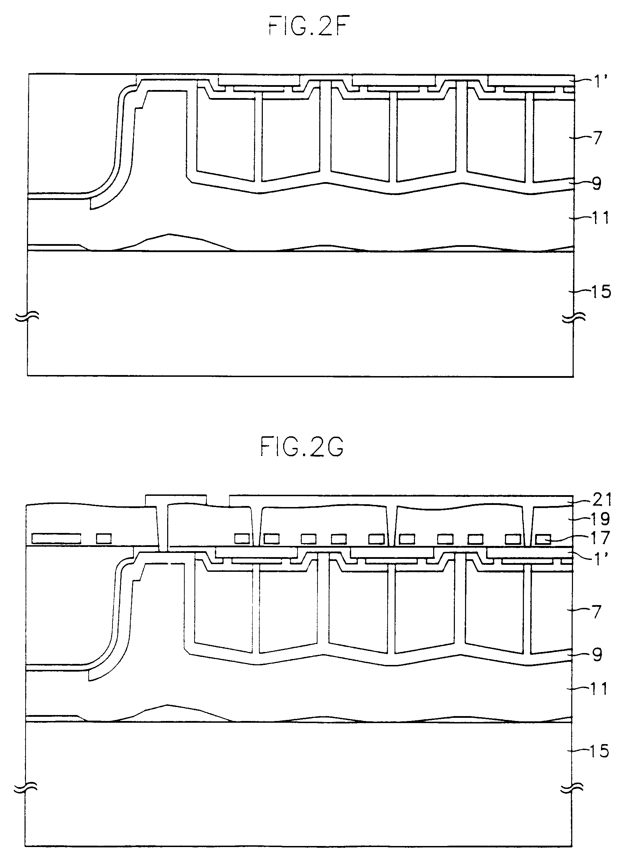

Referring now to FIG. 2F, being turned upside down, the backside of the wafer where the capacitors are formed is polished by CMP method using the insulating layer 3 as an etch stopper.

Successively, as shown in FIG. 2G, the gate electrode 17 is formed on the active silicon layer 1' remained after the CMP process, and the source/drain region is made by ion-implantation to form the switching elements. After that, the insulating layer 19 is applied and the bit line 21 is formed.

The above-mentioned contact is formed on the borderline between the cell part and the peripheral part to be connected with the plate node 9, the second conductive layer of the capacitor formed in the opposite side. The plate node 9 can be grounded after the insulating layer 3 formed in the field area and the dielectric layer for the capacitor are removed completely.

After the metallization and passivation processes, the processes of the memory cell are completed.

A second preferred embodiment of the method of manufacturing a DRAM by using SOI technology is described as follows.

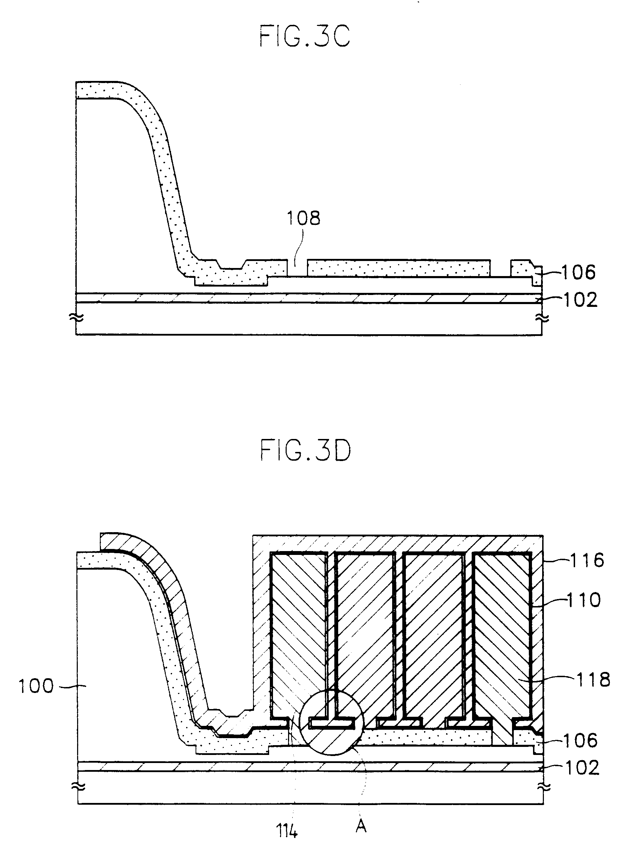

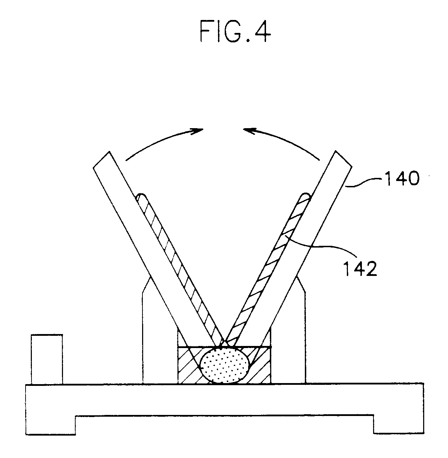

FIGS. 3A to 3I depict the steps in the manufacture of a DRAM by silicon-on-insulator processes in accordance with a second preferred embodiment of this invention. FIG. 4 depicts a joining machine that is used at the time of manufacturing the DRAM in accordance with the second preferred embodiment of this invention.

In the processes for making a DRAM in accordance with the second preferred embodiment of this invention, access transistors of cell areas are formed on SOI having a thickness of less than 100 nm. Another devices except the access transistors are formed on SOI having a thickness of 1µm so as to display the characteristics of the devices formed on a bulk silicon.

The processes therefor include a first step for recessing certain areas including the parts where DRAM cells are formed on a silicon substrate 100; a second step for forming wells on the substrate; a third step for forming a trench 104 to isolate electrical elements between cells and form align-keys on the recessed area; a fourth step for filling the trench 104 with a buried oxide 106; a fifth step for forming a buried contact 108 on the buried oxide 106; a sixth step for forming capacitors; a seventh step for planarizing a pattern formed through the above steps; an eighth step for cutting an active wafer on which the above steps are carried out to join it to a handle wafer 112; a ninth step for recessing the silicon of the active wafer nearly to the bottom of the trench formed in the third step; a tenth step for wet-etching the silicon formed on the area that is not recessed in the first step and isolating electrical elements by a local oxidation of silicon (LOCOS) process; an eleventh step for forming devices of peripheral circuits such as n-type MOS and p-type MOS transistors and register patterns after the above processes; a twelfth step for forming MOS transistors on the recessed area of the silicon substrate; a thirteenth step for forming simultaneously contacts and bit-line contacts on a plate node, a cell, gate electrodes of a peripheral circuit and a line of the peripheral circuit; a fourteenth step for forming a bit line of the cell area and a line of the peripheral circuit; and a fifteenth step for carrying out passivation and alloying on the pattern after the above steps.

The above steps are now in detail described with reference to the drawings.

As a first step, boron and Ge are ion-implanted by a high energy of 1E20/cm² on a bare silicon 100, and when the active wafer is thinned at the later process, an etchstopper layer 102 that can be used as an etchstopper is formed. After direct wafer bonding (DWB) treatment, the silicon of the area where a thin SOI is formed is wet-etched to a thickness of I and recessed. Recessing the oxide layer after local oxidation instead of the wet etching may be available but it has a difficulty of recessing the oxide layer to a depth of more than 1µm. The recess by wet-etching the silicon has a problem of uniformity of recessed depth. Therefore, boron and Ge are ion-implanted by a high energy of 1E20/cm² to use an etchstopper at the time of the recess. In this case, two etchstop layers 102 whose thicknesses differ from each other's.

The p-type well and n-type well are respectively formed by ion-implantation of boron and phosphorous in the second step.
The third step uses a thermal oxide layer of more than 30nm as a mask of the trench etching. The depth of the trench is over 150nm and below 300 nm, and patterning is carried out so that the area where electrical elements are isolated, the region where a contact of a plate node 116 is formed, and the align-key necessary for the sixth step. After the formation of the trench 104, boron or BF₂ is ion-implanted for doping the element-isolated area, and the oxide layer serving as the mask is removed.

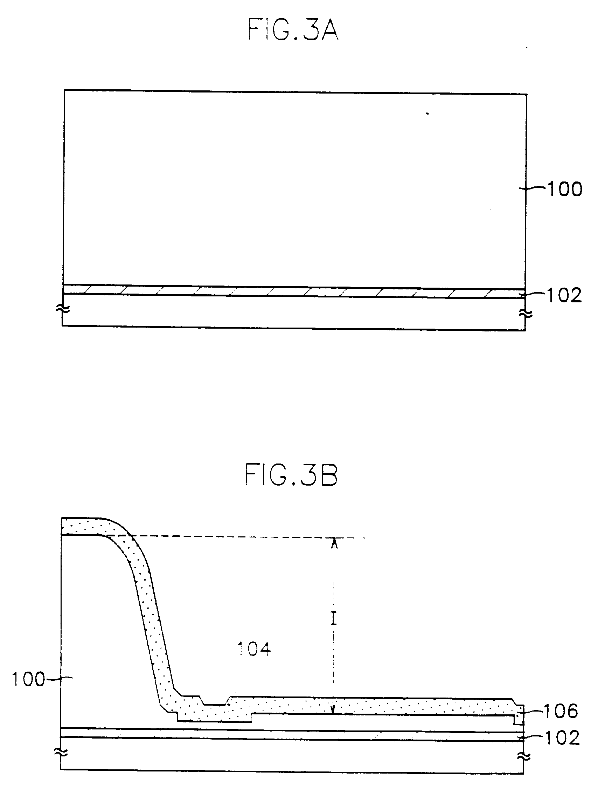

After the thermal oxide layer is grown to a thickness of 10nm, and an oxide layer by CVD is applied thereto thickly more than the depth of the trench, a silicon nitride layer of 10nm is deposited, and an oxide layer by CVD is deposited thereby making the state of FIG. 3B. The reason why the silicon nitride layer is inserted between the oxide layers is that a plate poly 120 is
deposited between the storage node 118 and the buried oxide 106 (silicon oxide layer/silicon nitride layer) thereby increasing the capacitance of the capacitor and the SOI serves as a back gate.

In the fifth step, the buried contact 108 is formed on the buried oxide 106 (thermal oxide + HTO + SiN + HTO), and this contact 108 connects the storage node to the thin SOI. Phosphorous is ion-implanted to the above contact.

The capacitor formed in the sixth step has a cylindrical shape or a crown shape in accordance with the design rule, required stored capacitance, etc. After insitu phosphorous doped poly silicon is applied to a thickness of more 200 nm than the depth of the recess in order that the planarity is good at the time of patterning the storage node 118 and the align-key formed in the third step is exposed, the storage node is patterned by CMP method. The oxide layer is wet-etched provided the oxide layer applied in the fourth step is exposed by dry-etching the storage poly 114, The silicon nitride layer formed in the fourth step serves as a stopping layer of the etching. When silicon nitride layer/oxide layer (NO) dielectric layer is formed and insitu- doped poly is applied, the plate poly 116 is applied between the storage node 118 and buried oxide, as shown in a circle A of FIG. 3D. The plate poly 116 is applied to a thickness of 100 to 200 and patterned to have a configuration of FIG. 3D.

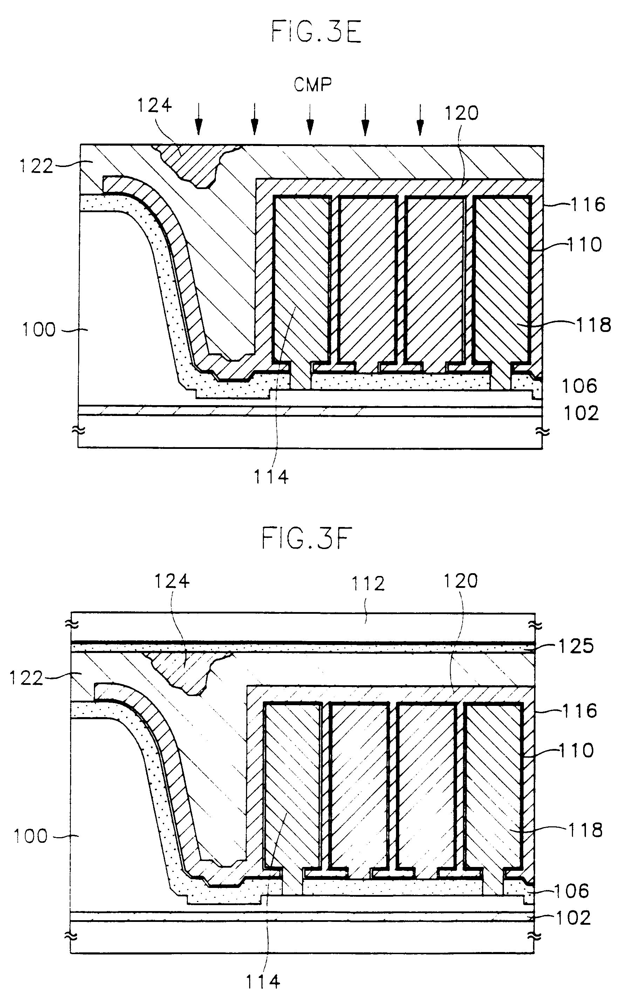

The seventh step is a step for polishing global topology and undulated surface so that DWB process is possible. The oxide layer by CVD and a borophosphorsilicate glass (BPSG) 122 are applied and reflow is carried out at a temperature of more than 800°C. Polysilicon 124 is applied and the CMP process is carried out to form the configuration of FIG. 3E. The BPSG 122 serves as a stopping layer of this CMP process. The oxide layer by CVD (including the BPSG 122) is overlaid and thermal treatment is carried out to complete the planarization.

The eighth step is a step for joining the handle wafer 112
and the active wafer formed through the 7th step, and includes the following three stages. As a first stage, the active wafer and the handle wafer that will be joined together are dipped respectively in a mixed solution of sulfuric acid and aqueous hydrogenperoxide of 130°C and a mixed solution of liquid ammonia and aqueous hydrogenperoxide of 80°C for a few minutes. The two wafers are dried and their particles are then removed such that their surfaces are terminated to an alkali radical.

As a second stage, two wafers join the joining machine shown in FIG. 4, with the planarized surface of the active wafer facing the glass side of the handle wafer.

The following table 1 shows that misalignment of the rotational direction may be controlled at an angle of less than 0.01 if the wafers are joined together by using the joining machine. Big misalignment causes a problem of alignment in the photoetching process after the tenth step.

As a third stage, two wafers are thermally treated for more than two hours in an ambient of nitrogen at a temperature of over 800°C, and, successively, a thermal oxide layer is then formed in an ambient of oxygen in order to increase joining intensity
and remove voids of the joining interface. Forming the thermal oxide layer can prevent the handle wafer from being damaged at the time of wet-etching the silicon.

**Table 1**

| The Result of Gauging the Misalignment of the Rotational Direction After the Joining of the Two Wafers | |
|---|---|
| Sample No. | Measured Degree |
| 1 | 0.008° |
| 2 | 0.008° |
| 3 | 0.001° |

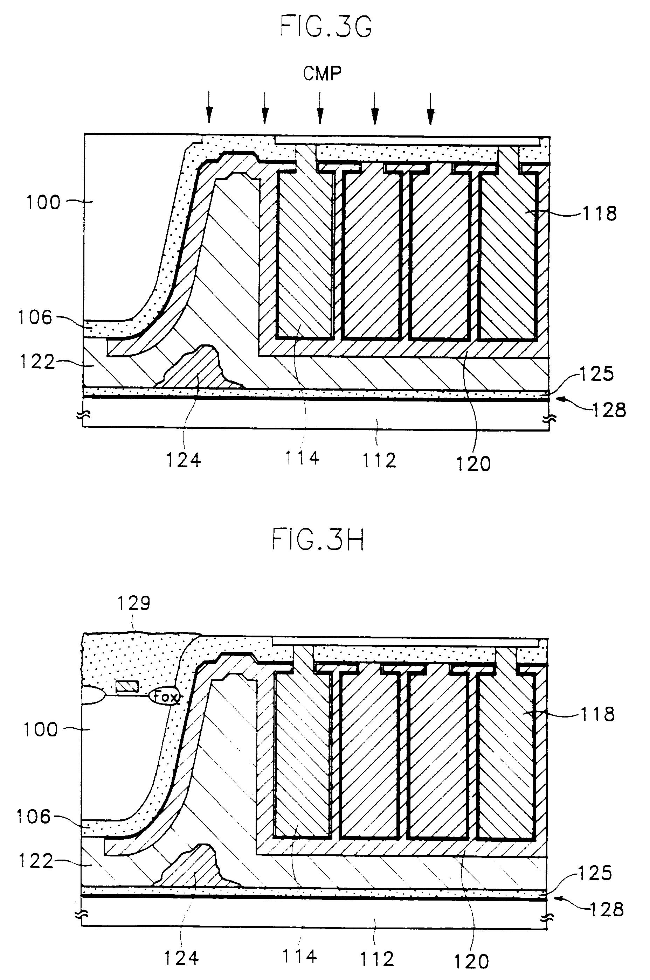

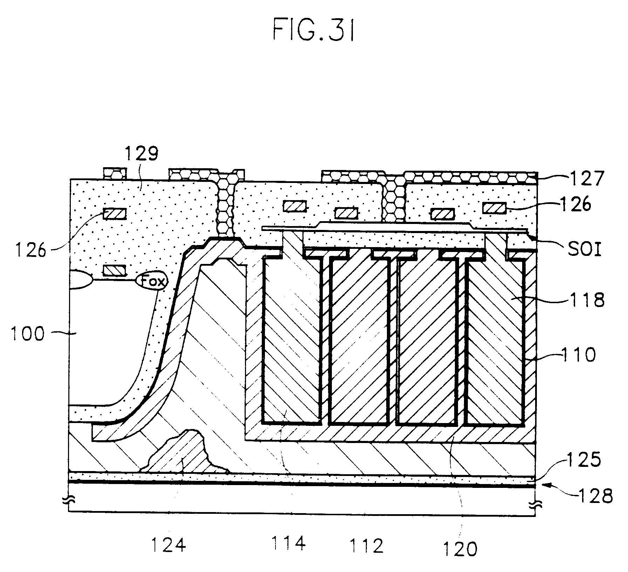

In the next 9th step, the active wafer passes through a series of backlapping/wet-etching/CMP. The backlapping is used for the purpose of enhancing the throughput, since the speed of removing the silicon just by CMP is too slow. The wet-etching removes silicon particles produced by the backlapping to decrease occurrence of scatches and deterioration of the wafer in the subsequent CMP process and uniform the thickness of the silicon layer by using an etchstopper. The silicon layer is thinned to a thickness of 50µm by the backlapping, and is then thinned to several micro-meters by means of a mixed solution of KOH/IPA of about 80°C in the wet-etching. The remained silicon is thinned by CMP. The oxide layer filled in the trench in the fourth step serves as a polish stopper, as shown in FIG. 3G.

Referring now to the tenth step, the thin SOI area, i.e. the recessed area is covered with a silicon oxide layer/silicon nitride layer/silicon oxide layer. The silicon in the thick SOI area is wet-etched to form a step-like difference of about 300nm between the thin SOI area and the thick SOI area. After that, isolation of electrical elements is performed in the thick SOI area by LOCOS. The oxide layer formed on the nitride layer in the thin SOI area is removed under the etching process of the oxide layer, and the nitride layer and the oxide layer formed underneath the nitride layer are remained. In the eleventh step, after n-type and p-type MOS transistors, register patterns, etc. are formed, an oxide layer formed by CVD is applied thereto such that it is higher than the top of the silicon nitride layer remained in the thick SOI area by about 200nm. The CVD oxide layer is planarized by CMP, by using the nitride layer as a stopper. The nitride layer and the oxide layer are wet-etched to have a configuration as shown in FIG. 3H.

In the twelfth step, a thermal oxide layer of 50 nm is formed. An oxide layer is formed to a thickness of more than 150nm in the region having the phosphorous out-diffused in the storage node 118 formed in the sixth step after the ion-implantation in the fifth step. The oxide layer of 60nm is wet-etched and the gate oxide layer is again formed. Gate electrodes I, II 124, 124' are then formed, and source/drain is formed to form SOI transistor. The gate electrode 124 is formed of metal, e.g. W or composite of Ti nitride layer and metal, and then patterned to be a line of thick SOI region simultaneously with patterning the gate line. After that, a CVD oxide layer is applied as an interlayer insulating layer.

In the thirteenth step, a contact and a bit line contact are simultaneously formed over the plate node 116, cell, gate electrode of the peripheral circuit, metallization of the peripheral circuit.

Referring now to FIG. 14, the bit-line 127 is formed on the pattern where the contact is formed. The bit-line is formed of metal, and is patterned simultaneously with the line of the thick SOI region to have a structure of FIG. 3I. The reference numerals appearing in the drawing designate the following elements: ONO 110; an oxide layer 125; a bonded interface 128; and SiO₂ 129. When it comes to the fifteenth step, customary semiconductor manufacturing processes such as passivation and alloying are carried out on the pattern to complete a DRAM.

In the first preferred embodiment of this invention, even if the storage node is raised to secure the capacitance of the capacitor at the time of manufacturing a DRAM, there is no problem of step-like difference between the peripheral area and the area. Besides, even if the device is highly integrated, the area where one capacitor occupies is relatively small but the height may be increased as much as you like, and the sufficient capacitance of the capacitor can be secured. Since the processes for manufacturing the DRAM begin with forming the capacitor and the transistor is then formed, there can be prevented the deterioration to the characteristic of the transistor due to the weak of the junction caused by the subsequent thermal treatment. Thus, the subsequent processes may be easily carried out. Since the cell area is recessed by the shallow trench method, a thick oxide layer is not used at the time of the isolation of electrical elements to facilitate the formation of the contact for grounding the plate node of the capacitor on the borderline of the peripheral area and the cell area. Referring to the second preferred embodiment, the advantages of DWB and SOI techniques are maintained intact by forming the SOI devices just in the specified areas including the cell area, and there can be solved problems such as step coverage and etch damage caused by increasing the planarity to overcome the step-like difference of the capacitor. The technique applied to the bulk silicon may be directly to the devices of the peripheral circuit.

## Claims

1. A method for making a dynamic random access memory comprising the steps of:
recessing a cell area of a lower surface of a silicon substrate (1) by a first depth, wherein the substrate has the lower surface and an upper surface opposite the lower surface, and the lower surface is divided into the cell area where a memory device is formed and a peripheral area;
forming a trench having a bottom area and a sidewall into the recessed cell area;
forming a first insulating layer (3) over the lower surface;
forming a contact hole in the first insulating layer;
depositing and patterning a first conductive layer (5, 7) to form a storage node (6) in contact with the lower surface of the substrate through the contact hole;
forming a dielectric layer on the storage node;
forming a second conductive layer on the dielectric layer to form a plate node (9);
planarizing the lower surface of the substrate; polishing the upper surface to expose the first insulating layer filled in the trench such that a portion of the upper surface opposite the cell area has a thin silicon-on-insulator layer surrounded by the trench and a portion of the upper surface opposite the peripheral area has a thick silicon-on-insulator layer; and
forming a switching element on the upper surface of the thin silicon-on-insulator layer and the thick silicon-on-insulator layer.

2. The method according to Claim 1, wherein the step of depositing and patterning the first conductive layer comprises the substeps of:
forming an undoped polysilicon layer (5) over the lower surface in contact with the lower surface throughout the contact hole; and
forming a doped polysilicon layer (7) over the undoped polysilicon layer.

3. The method of Claim 1, wherein the first depth is greater than the combined thickness of the first insulating layer, the first conductive layer, the dielectric layer, and the second conductive layer.

4. The method of Claim 3, further comprising the step of bonding a handling wafer (15) to the planarized lower surface prior to polishing the upper surface.

5. The method of Claim 1, further comprising the step of forming a planarizing layer before planarizing the lower surface of the substrate.

6. A method for making a dynamic random access memory as claimed in Claim 1, comprising:
forming a well on the lower surface of said silicon substrate (1); filling the trench with buried oxide (105); forming a buried contact (108) on said buried oxide; forming a capacitor; planarizing a pattern formed by said processes; bonding the lower surface of the substrate (1) to a second substrate (15) forming a handling wafer; removing silicon to the bottom of said trench; wet-etching a silicon layer formed on an area that is not recessed on said silicon substrate and performing isolation of electrical elements by means of a local oxidation of silicon process; forming devices of a peripheral circuit such as n-type and p-type metal oxide semiconductors and a register pattern in a conventional manner; forming devices such as a metal oxide semiconductor and a transistor on the recessed area of said silicon substrate; forming contacts simultaneously on a plate node, a cell, a gate and a metallization of the peripheral circuit and on a bit line, respectively; forming simultaneously a bit line (127) of the cell area and the metallization of the peripheral circuit; and carrying out passivation and alloying on said pattern.

7. The method according to Claim 6, wherein the step of recessing the silicon to the bottom of said trench follows lapping/wet-etching/chemical-and-mechanical polishing.

8. The method according to Claim 6 or 7, wherein an etchstopping layer is formed so as to facilitate said lapping/wet-etching/chemical-and-mechanical polishing process prior to recessing the specified area.

9. The method according to any one of Claims 6 to 8, wherein an etchstopping layer is formed so as to facilitate recessing the specified area prior to said process.

10. The method according to any one of Claims 6 to 9, wherein said planarization process includes a chemical-and-mechanical polishing process after applying a buried oxide and overlaying polysilicon or amorphous silicon.

11. The method according to any one of Claims 6 to 10, wherein the lower surface of the substrate is bonded to the handling wafer after an SiO₂ layer is formed.

12. The method according to any one of Claims 6 to 11, wherein the bonding process to the handling wafer is carried out by successively and thermally treating in an ambient of 0₂ after thermal treatment in an ambient of N₂.

13. The method according to any one of Claims 6 to 11, wherein a gate electrode of said metal oxide semiconductor in the cell area and the line of the peripheral circuit are simultaneously formed.

14. The method according to any one of Claims 6 to 11, wherein isolation of electrical elements using a local oxidation of silicon process is performed by making devices of the peripheral area and applying an interlayer insulating layer after covering a silicon oxide layer/silicon nitride layer/silicon oxide layer on a specified area including the cell, and then carrying out a planarization in a chemical-mechanical polishing method, using the silicon nitride layer of a predetermined area as a stopper.

15. The method according to any one of Claims 6 to 14, wherein said process for making the capacitor a plate node of said capacitor penetrates between the buried oxide and the storage node.

## Patentansprüche

1. Verfahren zur Herstellung eines dynamischen Schreib-Lese-Speichers, welches die folgenden Schritte umfasst:
- Herstellung einer Ausnehmung in einer Zellenfläche einer unteren Oberfläche eines Siliziumsubstrates (1) nach Maßgabe einer ersten Tiefe, wobei das Substrat eine untere Oberfläche und eine obere, der unteren Oberfläche gegenüberliegende Oberfläche aufweist und wobei die untere Oberfläche in eine Zellenfläche unterteilt ist, in der ein Speicher gebildet wird und eine periphere Fläche;
- Herstellung eines Grabens innerhalb der Ausnehmung der Zellenfläche, der eine Bodenfläche und eine Seitenwandung aufweist;
- Herstellung einer ersten Isolationsschicht (3) über der unteren Oberfläche;
- Herstellung einer Kontaktbohrung in der ersten Isolationsschicht (3);
- Auftragung und Strukturierung einer ersten leitfähigen Schicht (5,7) zwecks Bildung eines Speicherknotens (6), der mit der unteren Oberfläche des Substrats über die Kontaktbohrung in Verbindung steht;
- Herstellung einer dielektrischen Schicht auf dem Speicherknoten (6);
- Herstellung einer zweiten leitfähigen Schicht auf der dielektrischen Schicht, um einen Plattenknoten (9) zu bilden;
- Planarisierung der unteren Oberfläche des Substrates;
- Polieren der oberen Oberfläche und Belichten der ersten Isolationsschicht, die in den Graben eingefüllt worden ist, so dass ein Teil der oberen Oberfläche, der der Zellenfläche gegenüberliegt, eine dünne Siliziumschicht aufweist, die sich auf der Isolationsschicht befindet und die durch den Graben umgeben ist und ein Teil der oberen Oberfläche, der der peripheren Fläche gegenüberliegt, eine dicke Siliziumschicht aufweist, die sich auf der Isolationsschicht befindet; und
- Herstellung eines Schaltelements auf der oberen Oberfläche der dünnen Siliziumschicht, die sich auf der lsolationsschicht befindet und der dicken Siliziumschicht, die sich auf der Isolationsschicht befindet.

2. Verfahren nach Anspruch 1, wobei der Schritt des Auftragens und der Strukturierung der ersten leitfähigen Schicht die weiteren Unterschritte umfasst:
- Herstellung einer undotierten Polysiliziumschicht (5) über der unteren Oberfläche, die sich über die Kontaktbohrung in Berührung mit der unteren Oberfläche befindet; und
- Herstellung einer dotierten Polysiliziumschicht (7) über der undotierten Polysiliziumschicht.

3. Verfahren nach Anspruch 1, wobei die erste Tiefe größer ist als die kombinierten Dicken der ersten Isolationsschicht, der ersten leitfähigen Schicht, der dielektrischen Schicht und der zweiten leitfähigen Schicht.

4. Verfahren nach Anspruch 3, welches ferner den Verfahrensschritt der Anbindung einer Handhabungsscheibe (15) an die planarisierte untere Oberfläche umfasst, und zwar vor dem Polieren der oberen Oberfläche.

5. Verfahren nach Anspruch 1, welches ferner den Verfahrensschritt der Ausbildung einer ebenen Schicht umfasst, und zwar bevor die untere Oberfläche des Substrates planarisiert wird.

6. Verfahren zur Herstellung eines dynamischen Schreib-Lese-Speichers gemäß Anspruch 1, welches die folgenden Verfahrensschritte umfasst:
- Herstellung einer Mulde in der unteren Oberfläche des genannten Siliziumsubstrates (1); Ausfüllen des Grabens mit einem verdeckten Oxid (105); Herstellung eines verdeckten Kontaktes (108) an dem genannten verdeckten Oxid; Herstellung eines Kondensators; Planarisierung einer Struktur, die im Rahmen dieser Verfahren hergestellt worden ist; Anbindung der unteren Oberfläche des Substrates (1) an ein zweites Substrat (15) zwecks Herstellung einer Handhabungsscheibe; Entfernung des Siliziums am Boden des Grabens; Nassätzung einer Siliziumschicht, die auf einer Fläche gebildet worden ist, die keine Ausnehmung in dem genannten Siliziumsubstrat aufweist und Durchführung einer Isolation elektrischer Elemente mittels eines ein lokales Oxidierens des Silizium bewirkenden Verfahrens; Herstellung von Mitteln eines peripheren Kreises wie n-Typ und p-Typ Metalloxidhalbleiter und einer Registerstruktur nach Maßgabe eines herkömmlichen Verfahrens; Herstellung von Mitteln wie einem Metalloxidhalbleiter und einem Transistor auf der, durch eine Ausnehmung gekennzeichneten Fläche des genannten Siliziumsubstrates; gleichzeitiges Herstellen von Kontakten auf einem Plattenknoten, einer Zelle, einem Gatter und Metalllisieren des peripheren Schaltkreises und jeweils einer Bitleitung; gleichzeitiges Herstellen einer Bitleitung (127) der Zellenfläche und Metalllisieren des peripheren Schaltkreises; Durchführung einer Passivierung und Legierung der genannten Struktur.

7. Verfahren nach Anspruch 6, wobei sich an den Schritt der Bildung einer Ausnehmung in dem Silizium bis zum Boden des Grabens die Verfahrensschritte eines Läppens, eines Nassätzens, eines chemischen und mechanischen Polierens anschließen.

8. Verfahren nach Anspruch 6 oder 7, wobei eine Ätzhemmschicht gebildet wird, um die Verfahrensschritte des Läppens, des Nassätzens, des chemischen und mechanischen Polierens vor der Bildung einer Ausnehmung in der jeweiligen Fläche zu erleichtern.

9. Verfahren nach einem der Ansprüche 6 bis 8, wobei eine Ätzhemmschicht gebildet wird, um das Erzeugen von Ausnehmungen in der jeweiligen Fläche vor diesen Verfahren zu erleichtern.

10. Verfahren nach einem der Ansprüche 6 bis 9, wobei das genannte, auf die Planarisierung gerichtete Verfahren ein chemisches und mechanisches Polierverfahren einschließt, und zwar im Anschluss an die Erzeugung eines verdeckten Oxids und dessen Überlagerung mit Polysilizium oder amorphem Silizium.

11. Verfahren nach einem der Ansprüche 6 bis 10, wobei die untere Oberfläche des Substrates an die Handhabungsscheibe angebunden wird, und zwar nachdem eine SiO2 Schicht gebildet worden ist.

12. Verfahren nach einem der Ansprüche 6 bis 11, wobei das Anbindungsverfahren an die Handhabungsscheibe durchgeführt wird, indem aufeinander folgend eine thermische Behandlung in einer Sauerstoffatmosphäre im Anschluss an eine thermische Behandlung in einer Stickstoffatmosphäre durchgeführt werden.

13. Verfahren nach einem der Ansprüche 6 bis 11, wobei eine Gatterelektrode des genannten Metalloxidhalbleiters in der Zellenfläche und die Leitung des peripheren Schaltkreises gleichzeitig hergestellt werden.

14. Verfahren nach einem der Ansprüche 6 bis 11, wobei eine Isolation elektrischer Elemente durchgeführt wird, indem ein, auf eine örtliche Oxidation von Silizium gerichtetes Verfahren durchgeführt wird, und zwar während die Mittel des peripheren Kreises hergestellt werden und wobei eine Zwischenisolierschicht aufgebracht wird, und zwar nachdem eine Schichtenfolge bestehend aus Siliziumoxid, Siliziumnitrid, Siliziumoxid in einer jeweiligen Fläche einschließlich der Zelle aufgetragen worden ist, woraufhin eine Planarisierung nach Art eines chemischen und mechanischen Polierverfahrens durchgeführt wird, wobei die Siliziumnitridschicht einer vorherbestimmten Fläche als Hemmschicht benutzt wird.

15. Verfahren nach einem der Ansprüche 6 bis 14, wobei sich im Rahmen des Verfahrens zur Herstellung des Kondensators ein Plattenknoten des Kondensators zwischen dem verdeckten Oxid und dem Speicherknoten erstreckt.

## Revendications

1. Méthode pour fabriquer une mémoire vive dynamique (DRAM) comprenant les étapes suivantes:
pratiquant un évidement dans l'aire cellulaire de la surface inférieure d'un substrat en silicium (1) à une première profondeur, de façon à ce que le substrat ait une surface inférieure et une surface de dessus faisant face à la surface inférieure, et que la surface inférieure soit divisée en l'aire cellulaire où un dispositif mémoire sera formé, et en un espace périphérique;
pratiquant une tranchée ayant une partie de fond et une paroi latérale dans l'aire cellulaire évidée;
formant une première couche isolante (3) venant sur la surface inférieure;
pratiquant un orifice de contact dans la première couche isolante;
déposant et gravant une première couche conductrice (5,7) pour former une borne d'emmagasinage (6) en contact avec la surface inférieure du substrat par l'orifice de contact;
formant une couche diélectrique sur la borne d'emmagasinage;
formant une deuxième couche conductrice sur la couche diélectrique pour former une borne à plaques (9);
planarisant la surface inférieure du substrat; polissant la surface de dessus pour exposer la première couche isolante dans la tranchée de façon à ce qu'une portion de la surface de dessus à l'opposé de la région cellulaire comporte une couche mince de silicium-sur-isolant à l'intérieur de la tranchée et qu'une portion de la surface de dessus en face de l'espace périphérique comporte une couche épaisse de silicium-sur-isolant; et
formant un élément de commutation sur la surface de dessus de la couche mince de silicium-sur-isolant et de la couche épaisse de silicium-sur-isolant.

2. Méthode selon la revendication 1, dans laquelle l'étape de déposer et de graver la première couche conductrice comprend les sous-étapes suivantes:
formation d'une couche de polysilicium non-dopé (5) sur la surface inférieure en contact avec la surface inférieure tout au long de l'orifice de contact; et
formation d'une couche de polysilicium dopé (7) sur la couche de polysilicium non-dopé.

3. Méthode selon la revendication 1, dans laquelle la première profondeur est plus grande que les épaisseurs combinées de la première couche isolante, la première couche conductrice, la couche diélectrique, et la deuxième couche conductrice.

4. Méthode selon la revendication 3, comprenant de surcroît l'étape de fixer une plaque de maniement (15) sur la surface inférieure planarisée avant de polir la surface de dessus.

5. Méthode selon la revendication 1, comprenant de surcroît l'étape de former une couche planarisante avant de planariser la surface inférieure du substrat.

6. Méthode pour fabriquer une mémoire vive dynamique (DRAM) selon la revendication 1, comprenant les étapes suivantes:
formation d'un puits sur la surface inférieure du substrat en silicium (1); remplissant la tranchée avec de l'oxyde incorporé (105); formant un contact sous la surface (108) sur l'oxyde; formant un condensateur; planarisant un dessin formé par ces procédés, fixant la surface inférieure du substrat (1) à un deuxième substrat (15) formant ainsi une mince plaque de maniement; enlevant le silicium pour le mettre au fond de la tranchée; gravant au liquide une couche de silicium formée sur une région qui n'a pas d'évidement sur le substrat de silicium et effectuant une isolation des éléments électriques au moyen d'un procédé d'oxydation localisée de silicium; formant des dispositifs d'un circuit périphérique tels que des semi-conducteurs de type *n* et type *p* on oxyde de métal et un modèle de compteur de façon conventionnelle; formant des dispositifs tels qu'un semiconducteur et un transistor on oxyde de métal sur la région à évidement du substrat de silicium; formant des contacts simultanément sur une borne à plaques, une cellule, une porte et une métallisation du circuit périphérique et sur une ligne binaire, respectivement; formant simultanément une ligne binaire (127) de la région cellulaire et la métallisation du circuit périphérique; et effectuant une passivation et un dépôt électrolytique sur ce dessin.

7. Méthode selon la revendication 6, dans laquelle l'étape d'évidement du silicium jusqu'au fond de cette tranchée est consécutive au procédé d'ébarbage/gravage/polissage chimique et mécanique.

8. Méthode selon la revendication 6 ou 7, dans laquelle une couche résistant à la gravure est formée pour faciliter le procédé de polissage /gravage /polissage chimique et mécanique préalable à la pratique d'évidements de la région spécifiée.

9. Méthode selon l'une quelconque des revendications 6 à 8, dans laquelle une couche résistant à la gravure est formée de façon à faciliter l'évidement de la région spécifiée avant le procédé en question.

10. Méthode selon l'une quelconque des revendications 6 à 9, dans laquelle le processus de planarisation comprend un processus de polissage chimique et mécanique après l'application d'un oxyde incorporé et un revêtement de polysilicium ou de silicium amorphe.

11. Méthode selon l'une quelconque des revendications 6 à 10, dans laquelle la surface inférieure du substrat est fixée à la plaque de maniement après qu'une couche de SiO₂ ait été formée.

12. Méthode selon l'une quelconque des revendications 6 à 11, dans laquelle le procédé de fixation à la plaque de maniement est effectué par traitements thermiques successifs dans un milieu ambiant de O₂ après traitement thermique dans un milieu ambiant de N₂.

13. Méthode selon l'une quelconque des revendications 6 à 11, dans laquelle une électrode-porte du semi-conducteur d'oxyde de métal dans la région cellulaire et la ligne du circuit périphérique sont formées simultanément.

14. Méthode selon l'une quelconque des revendications 6 à 11, dans laquelle l'isolation des éléments électriques utilisant un procédé d'oxydation localisée de silicium est effectuée en formant des dispositifs de la région périphérique et appliquant une couche intermédiaire isolante après avoir couvert une couche d'oxyde de silicium/couche de nitrure de silicium/couche d'oxyde de silicium sur une région spécifique comprenant la cellule, et effectuant ensuite une planarisation avec une méthode de polissage chimique-mécanique, utilisant la couche de nitrure de silicium d'une région prédeterminée comme arrêt.

15. Méthode selon l'une quelconque des revendications 6 à 14, dans laquelle le procédé en question pour faire le condensateur [est] qu'une borne à plaques dudit condensateur pénêtre entre l'oxyde incorporé et la borne d'emmagasinage.
